(19)

Europäisches
Patentamt
European
Patent Office
Office européen
des brevets

(11)  **EP 1 939 333 A1**

(12)  **EUROPEAN PATENT APPLICATION**
published in accordance with Art. 153(4) EPC

(43) Date of publication:
**02.07.2008 Bulletin 2008/27**

(21) Application number: **06781840.1**

(22) Date of filing: **21.07.2006**

(51) Int Cl.:
*C30B 29/30* (2006.01)  *H01L 41/09* (2006.01)
*H01L 41/18* (2006.01)  *H01L 41/22* (2006.01)
*H03H 9/25* (2006.01)

(86) International application number:
**PCT/JP2006/314929**

(87) International publication number:
**WO 2007/046176 (26.04.2007 Gazette 2007/17)**

(84) Designated Contracting States:
**DE**

(30) Priority: **19.10.2005 JP 2005303807**

(71) Applicant: **Yamaju Ceramics Co., Ltd.**
**Owariasahi City, Aichi 488-0012 (JP)**

(72) Inventors:
• **KURACHI, Masato**
**Seto City, Aichi 489-0003 (JP)**

• **KANNO, Kazuya**
**Seto City, Aichi 489-0003 (JP)**
• **YAGI, Toru**
**Seto City, Aichi 489-0003 (JP)**
• **SASAMATA, Takeji**
**Seto City, Aichi 489-0003 (JP)**
• **SAHASHI, Ietaka**
**Seto City, Aichi 489-0003 (JP)**

(74) Representative: **TBK-Patent**
**Bavariaring 4-6**
**80336 München (DE)**

(54)  **FERROELECTRIC SINGLE CRYSTAL, SURFACE ACOUSTIC FILTER MAKING USE OF THE SAME AND PROCESS FOR PRODUCING THE FILTER**

(57)    The present invention provides a lithium tantalate (LT) single crystal or a lithium niobate (LN) single crystal, which has strong resistance to stress shock or thermal shock, and a surface acoustic wave filter comprising a piezoelectric substrate produced from the single crystal. The lithium tantalate single crystal or lithium niobate single crystal of the invention contains at least one additional element selected from the group consisting of iron, copper, manganese, molybdenum, cobalt, nickel, zinc, carbon, magnesium, titanium, tungsten, indium, tin, rhenium, scandium, rhodium, ruthenium, palladium, silver, platinum, gold, yttrium, neodymium, iridium, germanium, barium, cesium, strontium, gallium, cerium and other transition elements at a ratio of from 0.002wt% or more to 0.1 wt% or less, and has excellent stress shock characteristics and thermal shock characteristics.

EP 1 939 333 A1

**Description**

BACKGROUND OF THE INVENTION

1. Field of the Invention

The present invention relates to a lithium tantalate single crystal and a lithium niobate single crystal, which are mainly used as piezoelectric substrates, and to a surface acoustic wave filter, comprising a piezoelectric substrate produced from said single crystal, and a production method thereof.

2. Description of the Related Art

A surface acoustic wave (hereinafter abbreviated as "SAW") filter, which uses surface acoustic waves, comprises fine comb-shaped electrodes formed on the surface of a piezoelectric substrate and is widely used in televisions, mobile phones, etc.

The surface acoustic wave filter is produced by forming an electrode thin film, made of aluminum or the like, on the surface of a piezoelectric substrate, and patterning the electrode thin film using photolithography to form an electrode having a given shape. Specifically, the electrode thin film is first formed on the piezoelectric substrate surface by, for example, sputtering. Then, organic resin (a photoresist) is applied on the electrode thin film, and the electrode film is pre-baked at high temperature. Subsequently, the electrode film is patterned by exposing it to light using a stepper. Then, the electrode film is post-baked at high temperature and developed, and the photoresist is dissolved. Finally, the electrode film is wet-etched or dry-etched, thus forming an electrode having a given shape.

Also, a lithium tantalate ($LiTaO_3$) single crystal (hereinafter abbreviated as an "LT single crystal") and a lithium niobate ($LiNbO_3$) single crystal (hereinafter abbreviated as an "LN single crystal") are known as ferroelectric single crystals and are widely used in piezoelectric substrates for surface acoustic wave filters (SAW filters), superconductive sensors, various piezoelectric sensors, vibrating actuators, etc.

Recently, with the increasingly high performance and high band frequency of mobile phones, the miniaturization or thinning of devices has progressed. Also, with the demand for an increase in the sensitivity of sensors and the like, the miniaturization and thinning of sensors and the like has likewise progressed. Accordingly, there has been a strong demand for thinning in single crystal substrates.

However, the LT single crystal substrate and the LN single crystal substrate have shortcomings in that they have poor processability, the cleavage crack of single crystals characteristically occurs, and breakages occur throughout the substrates due to low stress shock. Also, the LT single crystal and the LN single crystal have a characteristic in that the thermal expansion coefficients thereof vary greatly in different directions, and thus, when they are subjected to changes in temperature, stress deformation will occur therein, and in some cases, they will break quickly.

In the SAW filters, the demand for a reduction in volume has increased due to the increasingly high performance and high frequency band of mobile phones. That is, in a process of producing the SAW filters, the number of filters produced with a sheet of piezoelectric substrate increases, and thus either the crack of the substrate caused by thermal processes or the crack of the substrate caused by cutting processes leads to a great loss.

Also, due to the increase in the number of filters produced with a sheet of piezoelectric substrate, the width to which the piezoelectric substrate is cut needs to be narrow. In this case, when the cut width is narrowed, chipping occurring at the cut plane will expand to the resulting filter, and breakage will occur at the electrode portions on the filter, leading to decreased yield. When the cutting rate is reduced in order to prevent this phenomenon, additional time is required, leading to decreased productivity.

Various methods for such thinning and reduction in volume have been examined.

For example, an Si or glass sheet is applied to a substrate to increase the strength thereof, or taping or metal deposition are carried out in the cutting or polishing process to prevent crack or chipping.

In the above-described method either of joining the Si or glass sheet to the substrate to increase strength or of carrying out taping or metal deposition in the cutting or polishing process to prevent crack or chipping, the number of processes is increased, or productivity is decreased. Thus, there is a need to develop a single crystal substrate and an SAW filter comprising the same, in which there is few cracks, flaws or chippings in the cutting, grinding and heating stages of the process of producing the single crystal substrate, and there is also few cracks, flaws or chippings and good productivity is achieved in the production of the SAW filter.

SUMMARY OF THE INVENTION

Therefore, the present invention has been made in view of the above-mentioned problems, and it is an object of the present invention to provide a lithium tantalate (LT) single crystal or a lithium niobate (LN) single crystal, which has high stress shock resistance and thermal shock resistance, a surface acoustic wave filter comprising a piezoelectric substrate produced from said single crystal, and a production method thereof.

The present inventors have conducted many studies and repeated trials and errors to solve this problem and, as a result, have found that, when at least one additional element selected from the group consisting of iron, copper, manganese, molybdenum, cobalt, nickel, zinc, carbon, magnesium, titanium, tungsten, indium, tin, rhenium, scandium, rhodium, ruthenium, palladium, silver, platinum, gold, yttrium, neodymium, iridium, germanium, barium, cesium, strontium, gallium, cerium and other transition elements is contained in a lithium tantalate (LT) single crystal or a lithium niobate (LN) single crystal at a ratio of from 0.002wt% or more to 0.1 wt% or less, the stress shock or thermal shock characteristics of the single crystal is increased without causing any change in the piezoelectric characteristics, thereby completing the present invention.

<Lithium tantalate single crystal or lithium niobate single crystal>

The lithium tantalate (LT) single crystal or lithium niobate single crystal of the present invention is characterized in that it contains at least one additional element selected from the group consisting of iron, copper, manganese, molybdenum, cobalt, nickel, zinc, carbon, magnesium, titanium, tungsten, indium, tin, rhenium, scandium, rhodium, ruthenium, palladium, silver, platinum, gold, yttrium, neodymium, iridium, germanium, barium, cesium, strontium, gallium, cerium and other transition elements at a ratio of from 0.002wt% or more to 0.1 wt% or less and has excellent stress shock characteristics and thermal shock characteristics.

Also, the additional element is preferably contained at a ratio of from 0.002wt% or more to less than 0.01 wt%.

As described later, the LT or LN single crystal contains a given additional element at the above-specified ratio, and the shock characteristics and thermal shock characteristics are improved, and crack, flaw or chipping in the processing thereof is inhibited, leading to an increase in productivity.

The LT or LN single crystal containing iron as the additional element shows yellow or orange-colored in a wafer produced therefrom and is easily distinguished from an LT or LN single crystal, which shows white in a wafer in which the additional element is not contained. Also, the yellow or orange color of the LT or LN single crystal is uniform throughout the wafer, suggesting that the additional element iron is uniformly dispersed in the wafer.

Also, the LT or LN single crystal may be subjected to reduction treatment in order to inhibit a pyroelectric effect. The reduced LT or LN single crystal consists of a single crystal having an inhibited pyroelectric effect.

Also, the reduced LT or LN single crystal containing iron as the additional element shows dark yellow or dark orange in a wafer produced therefrom and is easily distinguished from an LT or LN single crystal, which does not contain the additional element. Also, the dark yellow or dark orange color of the reduced LT or LN single crystal is uniform throughout the wafer, suggesting that the additional element is uniformly dispersed in the wafer and that the reduction treatment is uniformly performed.

Also, a method of producing the reduced LT or LN single crystal may comprise a single crystal producing step and a reducing step of reducing the single crystal.

The single crystal producing step is a step of producing a lithium tantalate or a lithium niobate, which contains at least one additional element selected from the group consisting of iron, copper, manganese, molybdenum, cobalt, nickel, zinc, carbon, magnesium, titanium, tungsten, indium, tin, rhenium, scandium, rhodium, ruthenium, palladium, silver, platinum, gold, yttrium, neodymium, iridium, germanium, barium, cesium, strontium, gallium, cerium and other transition elements at a ratio of from 0.002wt% or more to 0.1 wt% or less and has excellent stress shock characteristics and thermal shock characteristics.

The LT or LN single crystal, obtained in the single crystal producing step, contains a given additional element in the above-specified ratio, and thus the stress shock characteristics and thermal shock characteristics are improved, and crack, flaw or chipping in the processing thereof is inhibited, leading to an increase in productivity.

As described in the Examples below, the LT or LN single crystal reduced in the reducing step can be efficiently produced, and consists of a single crystal having an inhibited pyroelectric effect.

A piezoelectric substrate produced from the LT or LN single crystal can be used not only in piezoelectric substrates for surface acoustic wave filters (SAW filters), but also in various substrates which need to be thinned or miniaturized. Examples of the substrates may include substrates for pyroelectric sensors, various piezoelectric sensors and vibrating actuators.

<Surface acoustic wave filter>

The surface acoustic wave filter of the present invention is characterized in that it comprises a piezoelectric substrates produced from a lithium tantalate single crystal or a lithium niobate single crystal, which comprise at least one additional element selected from the group consisting of iron, copper, manganese, molybdenum, cobalt, nickel, zinc, carbon, magnesium, titanium, tungsten, indium, tin, rhenium, scandium, rhodium, ruthenium, palladium, silver, platinum, gold, yttrium, neodymium, iridium, germanium, barium, cesium, strontium, gallium, cerium and other transition elements at a ratio of from 0.002wt% or more to 0.1 wt% or less and has excellent stress shock characteristics and thermal shock characteristics.

Also, the additional element in the single crystal is preferably contained at a ratio of from 0.002wt% or more to less than 0.01 wt%.

The piezoelectric substrate produced from the LT or LN single crystal containing iron as the additional element shows yellow or orange-colored, and thus is easily distinguished from a white piezoelectric substrate which does not contains the additional element. Also, the yellow or orange color of the piezoelectric substrate is uniform throughout the substrate, suggesting that the additional element iron is uniformly dispersed in the substrate.

Also, the piezoelectric substrate may consist of a piezoelectric substrate produced from the reduced lithium tantalate single crystal or lithium niobate single crystal. The reduced piezoelectric substrate consists of a piezoelectric substrate having an inhibited pyroelectric effect.

Also, the piezoelectric substrate containing iron as the additional element shows dark yellow or dark orange and is easily distinguished from a piezoelectric substrate produced from an LT or LN single crystal, which does not comprise the additional element. Also, the dark yellow or dark orange of the piezoelectric substrate is uniform throughout the substrate, suggesting that the additional element iron is uniformly dispersed in the substrate and that the reducing treatment is uniformly performed.

Because the surface acoustic wave filter of the present invention comprises the piezoelectric substrate produced from the inventive single crystal, crack, flaw or chipping during the processing thereof is inhibited, and processing precision during the cutting process is increased, leading to an increase in productivity. Also, during the storage or use of the surface acoustic wave filter, the occurrence of failures caused by shock or thermal shock is reduced.

<Method of producing surface acoustic wave filter>

A method of producing the surface acoustic wave filter of the present invention comprises a piezoelectric substrate-preparing step of preparing a piezoelectric substrate, produced from LT single crystal or LN single crystal which contains at least one additional element selected from the group consisting of iron, copper, manganese, molybdenum, cobalt, nickel, zinc, carbon, magnesium, titanium, tungsten, indium, tin, rhenium, scandium, rhodium, ruthenium, palladium, silver, platinum, gold, yttrium, neodymium, iridium, germanium, barium, cesium, strontium, gallium, cerium and other transition elements at a ratio of from 0.002wt% or more to 0.1 wt% or less, and has excellent stress shock characteristics and thermal shock characteristics; an electrode thin film-forming step of forming an electrode thin film on the surface of the piezoelectric substrate; an electrode-forming step of and subjecting the electrode thin film to photolithography to form an electrode having a given shape.

Specifically, in the method of producing the surface acoustic wave filter according to the present invention, the piezoelectric substrate produced from the inventive lithium tantalate single crystal or lithium niobate single crystal is used, and an electrode is formed on the surface of the piezoelectric substrate. Also, a piezoelectric substrate produced from the reduced lithium tantalate single crystal or lithium niobate single crystal may be used.

When the piezoelectric substrate made of the single crystal of the present invention is used, crack, flaw or chipping in all processes, including cutting, polishing and thermal processing, can be inhibited, and the failure rate can be reduced, leading to an increase in productivity. Also, processes, including cutting and polishing, can be rapidly performed, and the surface acoustic wave filter can be efficiently produced.

Also, the piezoelectric substrate-preparing step may comprise a reducing step of reducing the piezoelectric substrate produced from the lithium tantalate single crystal or lithium niobate single crystal. When the reducing step is carried out, a surface acoustic wave filter having an inhibited pyroelectric effect can be produced.

BRIEF DESCRIPTION OF THE DRAWINGS

The above and other objects and features of the present invention will become apparent from the following description of a preferred embodiment, given in conjunction with the accompanying drawings, in which:

FIG. 1 is a perspective view showing an example of a surface acoustic wave filter according to an embodiment of the present invention;

FIG. 2 is a graphic diagram showing the comparison of deflective strength according to the difference in thickness between an LT single crystal wafer having an iron content of 0.02 wt% and an LT single crystal wafer having no additional element;

FIG. 3 is a micrograph showing the cut plane of an LT single crystal wafer having an iron content of 0.02 wt% and an LT single crystal wafer containing no additional element; and

FIG. 4 is a graphic diagram showing the comparison of volume resistivity and surface potential before and after thermal treatment between a reduced LT single crystal wafer containing no additional element and a reduced LT single crystal wafer having an iron content of 0.01 wt%.

DETAILED DESCRIPTION OF THE PREFERRED EMBODIMENTS

Various embodiments of the present invention will now be described in detail with reference to the accompanying drawings.

The present invention is not limited by the following embodiments. Those skilled in the art will appreciate that various modifications, additions and substitutions are possible, without departing from the scope and spirit of the invention as disclosed in the accompanying claims.

<lithium tantalate single crystal and lithium niobate single crystal >

The lithium tantalate (LT) single crystal or lithium niobate (LN) single crystal of the present invention contains at least one additional element selected from the group consisting of iron, copper, manganese, molybdenum, cobalt, nickel, zinc, carbon, magnesium, titanium, tungsten, indium, tin, rhenium, scandium, rhodium, ruthenium, palladium, silver, platinum, gold, yttrium, neodymium, iridium, germanium, barium, cesium, strontium, gallium, cerium and other transition elements at a ratio of from 0.002wt% or more to 0.1 wt% or less, and has excellent stress shock characteristics and thermal shock characteristics.

The additional element may be any one, or two or more selected from among iron, copper, manganese, molybdenum, cobalt, nickel, zinc, carbon, magnesium, titanium, tungsten, indium, tin, rhenium, scandium, rhodium, ruthenium, palladium, silver, platinum, gold, yttrium, neodymium, iridium, germanium, barium, cesium, strontium, gallium, cerium and other transition elements.

The content of the additional element is the weight of the additional element based on the total weight of the inventive lithium tantalate single crystal or lithium niobate taken as 100 wt%.

When the additional element is contained at the above-specified ratio, the single crystal has improved shock characteristics and thermal characteristics. In order to obtain a single crystal having a more uniform single crystal, it is preferable to add the additional element at a ratio of from 0.002wt% or more to 0.1 wt% or less. More preferably, the content of the additional element is from 0.002wt% or more to less than 0.01 wt%.

<Method of producing reduced single crystal >

A method of producing the reduced lithium tantalate single crystal or lithium niobate single crystal of the present invention comprises a step of preparing the single crystal and a reducing step of reducing the single crystal.

The step of preparing the single crystal is not specifically limited. It can be prepared according to any known methods, including the Czochralski method. Specifically, the single crystal can be obtained by mixing and baking given raw materials to form a raw material mixture, melting the raw material mixture, immersing a seed crystal in the melt and allowing the seed crystal to grow.

Also, the step of reducing the prepared single crystal is not specifically limited, as long as it is a reducing step of inhibiting the pyroelectric effect. For example, the wafer can be reduced by introducing the additional element-containing lithium tantalate single crystal or lithium niobate single crystal and an alkaline metal compound-containing reducing agent in a treatment apparatus and maintaining the inside of the treatment apparatus at a temperature of 200-1000 °C in a vacuum.

<Surface acoustic wave filter >

The surface acoustic wave filter of the present invention comprises a piezoelectric substrate produced from a lithium tantalate single crystal or a lithium niobate single crystal, which contains at least one additional element selected from the group consisting of iron, copper, manganese, molybdenum, cobalt, nickel, zinc, carbon, magnesium, titanium, tungsten, indium, tin, rhenium, scandium, rhodium, ruthenium, palladium, silver, platinum, yttrium, neodymium, iridium, germanium, barium, cesium, strontium, gallium, cerium and other transition elements at a ratio of from 0.002wt% or more to 0.1 wt% or less, and has excellent stress shock characteristics and thermal shock characteristics.

Hereinafter, the surface acoustic wave filter according to one embodiment of the present invention will be described.

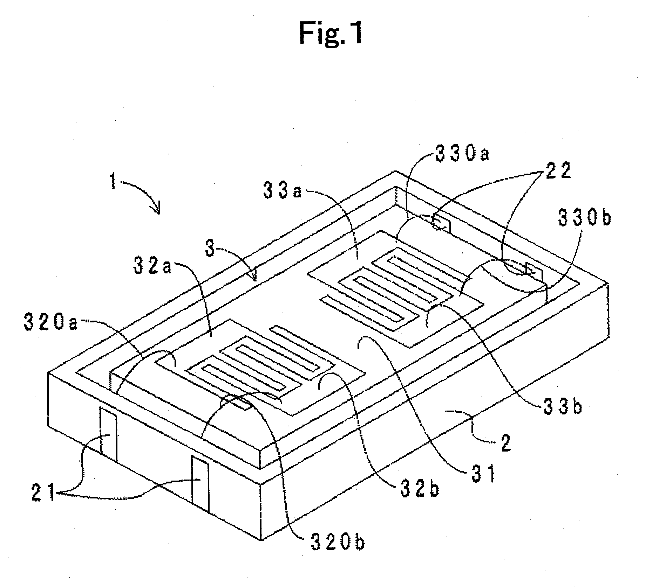

First, the construction of the surface acoustic wave filter according to an embodiment of the present invention will be described. FIG. 1 is a perspective view showing an example of the surface acoustic wave filter according to this embodiment. As shown in FIG. 1, a surface acoustic wave filter 1 comprises a case body 2 and a chip 3.

The case body 2 is made of ceramic material and has the shape of a rectangular parallelepiped box opened at the upper surface thereof. The case body 2 is closed with a cover (not shown) at the opening of the upper surface.

The chip 3 is received in the case body 2. The chip 3 comprises a piezoelectric substrate 31, input electrodes 32a and 32b and output electrodes 33a and 33b. The piezoelectric substrate 31 has a flat shape. The piezoelectric substrate 31 is made of a lithium tantalate single crystal containing iron at a ratio of 0.10 wt%.

The input electrodes 32a and 32b are made of aluminum and are comb-shaped. The input electrodes 32a and 32b are disposed on the surface of the piezoelectric substrate 31 opposite each other in the short length direction, such that the teeth thereof engage with each other. The input electrodes 32a and 32b are electrically connected with an input terminal 21, embedded in the case body 2, through conducting wires 320a and 320b.

Likewise, the output electrodes 33a and 33b are made of aluminum and are comb-shaped. The output electrodes 33a and 33b are disposed on the surface of the piezoelectric substrate 31 opposite each other in the short length direction, such that the teeth thereof engage with each other. Also, the output electrodes 33a and 33b are disposed opposite the input electrodes 32a and 32b in the lengthwise direction. The output electrodes 33a and 33b are electrically connected with an output electrode 22, embedded in the case body 2, through conducting wires 330a and 330b.

The operation of the surface acoustic wave filter according to the embodiment will now be described. First, voltage is applied to the input electrodes 32a and 32b from the input terminal 21 through the conducting wires 320a and 320b. Then, reverse distortion between the input electrodes 32a and 32b occurs due to the piezoelectric effect, and a surface acoustic wave is excited. This surface acoustic wave is transferred to the surface of the piezoelectric substrate 31. On the surface of the piezoelectric substrate 31, distortion occurs due to the transferred surface acoustic wave. Due to the distortion, electric charges are produced. The produced charges are outputted as electrical signals from the output electrodes 33a and 33b through the conducting wires 330a and 330b and the output terminal 22.

In the above embodiment, the piezoelectric substrate is produced from the lithium tantalate single crystal containing iron as the additional element. However, the additional element is not limited to iron, and may be selected from among the above-noted elements as appropriate. Also, the piezoelectric substrate may be produced from a lithium niobate single crystal containing a given additional element. For the inhibition of the pyroelectric effect, the piezoelectric substrate may also be produced from an LT or LN single crystal containing a given additional element subjected to reduction treatment. Also, the material of the input electrodes and the output electrodes is not limited to aluminum, but may be a metal, such as an aluminum alloy, copper or gold. Also, in the above embodiment, the case body made of ceramic material is used. However, the case body may be formed of other insulating materials, such as resin.

<Method of producing surface acoustic wave filter >

The method of producing the surface acoustic wave filter of the present invention comprises a piezoelectric substrate-preparing step, an electrode thin film-forming step and an electrode-forming step. Hereinafter, each of the steps will be described.

(1) Piezoelectric substrate-preparing step

This step is a step of preparing a piezoelectric substrate produced from a lithium tantalate single crystal or a lithium niobate single crystal, which contains at least one additional element selected from the group consisting of iron, copper, manganese, molybdenum, cobalt, nickel, zinc, carbon, magnesium titanium, tungsten, indium, tin, rhenium, scandium, rhodium, ruthenium, palladium, silver, platinum, gold, yttrium, neodymium, iridium, germanium, barium, cesium, strontium, gallium, cerium and other transition elements at a ratio of from 0.002wt% or more to 0.1 wt% or less and has excellent stress shock characteristics and thermal shock characteristics.

For example, a wafer, obtained by cutting any one of the inventive lithium tantalate single crystals or lithium niobate single crystals to a given thickness and polishing both sides of the cut crystal, may be prepared as the piezoelectric substrate. Also, even if any of the single crystals is used, the ratio of the additional element is preferably from 0.002wt% or more to 0.1 wt% or less. More preferably, it is from 0.002wt% or more to less than 0.01 wt%. For the inhibition of the pyroelectric effect, a reducing step of reducing the LT or LN single crystal containing the additional element may be carried out. Also, in pretreatment processes, cleaning or surface treatment of the piezoelectric substrate may be carried out.

(2) Electrode thin film-forming step

This step is a step of forming an electrode thin film on the surface of the piezoelectric substrate. The material of the electrode thin film may be a metal, such as aluminum, an aluminum alloy, copper or gold. The metal that is used as the metal of the electrode thin film is applied on the surface of the piezoelectric substrate to form the electrode thin film. The film can be formed using any known method, such as sputtering, vacuum deposition or chemical vapor deposition (CVD).

(3) Electrode-forming step

This step is a step of patterning the electrode thin film, formed on the surface of the piezoelectric substrate, using photolithography, to form an electrode having a given shape. This photolithography can be carried out in a conventional order. For example, organic resin as a photoresist is applied on the electrode thin film. Then, the film is pre-baked at a temperature of about 70-90°C. Then, the film is exposed to light through a photomask having a pattern (such as a metal electrode) formed thereon. Subsequently, the film is post-baked at 130 °C. Then, the film is developed, and the exposed region of the photoresist is removed. Finally, the film is wet-etched or dry-etched, thus forming an electrode having a given shape.

Also, in the present invention, after the electrode is formed, the piezoelectric substrate may be cut to a given size and received in the case. Then, the electrode may be connected with a given terminal, and the case may be closed, thus producing a surface acoustic wave filter.

Examples

Based on the above embodiment, the lithium tantalate single crystal of the present invention was prepared in various ways. Various measurements were performed on the prepared lithium tantalate single crystal, and the shock characteristics and thermal shock characteristics of the single crystal were evaluated. Hereinafter, the preparation, various measurements and evaluation of the lithium tantalate single crystal will be described. Also, the lithium tantalate single crystal will be abbreviated as an LT single crystal.

An LT single crystal containing 0-1.20 wt% of iron as an additional element was prepared using the Czochralski method. For this purpose, iron oxide ($Fe_2O_3$) as an iron source, lithium carbonate ($Li_2CO_3$) as a lithium source, and a tantalum oxide ($Ta_2O_5$) as a tantalum source, were mixed in prescribed amount with each other, and the mixture was baked at 1000 °C for 10 hours to form a raw material mixture. Also, the lithium carbonate and the tantalum pentoxide had a purity of 99.99%. Then, the raw material mixture was placed in a crucible made of iridium and was melted by high frequency induction heating. The melting temperature was 1700°C . A seed crystal cut in a given direction was immersed in the raw material mixture and grown while being revolved at a speed of 10 rpm at a lifting rate of 5 mm/hr, thus obtaining a single crystal having a diameter of about 80 mm and a length of about 60 mm.

Also, copper, cobalt, nickel, manganese, yttrium or titanium was used as an additional element to prepare LT single crystals having an additional element content of 0.10 wt%. The single crystals were prepared in the same manner as in the method of using iron as the additional element, except that an oxide of each additional element was used in place of iron oxide.

A crystal block having a thickness of 1 mm was cut at positions 5 mm and 60 mm from the upper end of each of the obtained crystals, respectively. As used herein, the term "upper end of a single crystal" means the end of the seed crystal in the axial direction in the single crystal, that is, the end that was lifted first. Then, one side of the cut crystal block was polished to produce wafers. Specifically, two kinds of wafers for each of the prepared LT single crystals, which had different cutting positions at the upper portion and the lower portion, were produced. Also, the wafer having a cutting position at the upper portion was designated "upper crystal wafer", and the wafer having a cutting position at the lower portion was designated "lower crystal wafer".

Also, the wafers had thicknesses of 350 μm, 300 μm, 250 μm, 200 μm, 180 μm and 150 μm, and the final polishing process was carried out using a mechanochemical polish method by colloidal silica.

The iron-containing LT single crystal showed red in the mass state. The wafer produced from the LT single crystal showed yellow or orange-colored, and it turned orange-colored with an increase in the iron content.

The wafers, produced from the prepared LT single crystal having iron contents of 0.001 wt%, 0.002 wt%, 0.005 wt%, 0.01 wt% and 0.02 wt%, respectively, showed yellow, and the wafers produced from the LT single crystals having iron contents of 0.10 wt%, 0.50 wt%, 1.00 wt% and 1.20 wt%, respectively, showed orange-colored. Also, the wafer produced from the LT single crystal containing no additional element showed white.

The yellow or orange color of the wafers was uniform throughout the wafers, suggesting that the additional element iron was uniformly dispersed in the wafers.

Also, wafers were produced from the iron-containing LT single crystals subjected to reduction treatment. Herein, the reduction treatment was carried out using an antistatic treatment apparatus comprising a treatment container, a heater and a vacuum pump. In the antistatic treatment apparatus, a pipe was connected to one side of the treatment container, and the vacuum pump was connected to the pipe. Through the connected pipe, gas was vented from the treatment container.

In the treatment container, each wafer was received, along with lithium chloride powder as a reducing agent. Each wafer was supported by a wafer cassette case made of quartz. The wafers were 4 inches (100 mm) in diameter and 0.5 mm in thickness. 50 sheets of wafers were disposed at an interval of about 5 mm. The lithium chloride powder was received in a Schale made of quartz glass, separately from the wafers. The amount of the received lithium chloride powder was about 100 g.

The heater was disposed such that it surrounded all sides of the treatment container.

An example of antistatic treatment using the antistatic treatment apparatus will now be described. First, the inside of the treatment container was set to a vacuum atmosphere of about 1.33 Pa using the vacuum pump. Then, the treatment container was heated using the heater, and the temperature within the treatment container was elevated to 550 °C after being heated for 3 hours. When the temperature within the treatment container reached at 550°C, the treatment container was maintained for 18 hours in that state. Then, the heater was stopped, and the inside of the treatment container was passively cooled, thus obtaining each of reduced wafers.

The wafers produced from the reduced LT single crystals having iron contents of 0.002-0.01 wt% and showing the original yellow color, respectively, showed dark yellow. The wafers, produced from the LT single crystals having iron contents of 0.05-1.20 wt% and showing the original orange color, respectively, showed dark orange after the reduction treatment.

Also, the wafer produced from the LT single crystal containing no additional element and reduced in the same manner as described above, changed from white to black due to the reduction treatment.

The upper crystal wafer and the lower crystal wafer produced for each of the LT single crystals, were subjected to various measurements. Hereinafter, measured items will first be described, and the measurement results and evaluation will then be described.

(1) Curie point measurement

The Curie points of the upper crystal wafer and the lower crystal wafer were measured with a differential thermal analyzer (DTA). The Curie point was measured at a total of five positions, including a central position on the wafer and four positions in an inner edge 5 mm apart from the edge of the wafer. Also, the difference between the Curie point of the upper crystal wafer and the Curie point of the lower crystal wafer was calculated. In the calculation of the difference of the Curie point, the value measured at the central portion of each of the wafers was used.

(2) Segregation of additional element

Whether the additional element in the upper crystal wafer and the lower crystal wafer (hereinafter abbreviated as "wafer") was segregated was visually observed. Also, the inside and outer circumferential portions of the wafers were visually observed under a white fluorescent lamp, and whether crystal defects, including cracks, bubbles and twin crystals, were present in the wafers was examined.

(3) Success rate of crystal growth and good product rate of wafer

The success rate of crystal growth was expressed as the percentage of the number of successes of crystal growth with respect to the number of crystal growth attempts.

Also, the good product rate was determined by cutting a 1 mm thick crystal block from a single crystal and expressing the percent of good quality products with respect to 100 products. As used herein, the term "good quality products" means that wafers having required thickness through cleaning and polishing processes experience no crack, flaw and chipping, and thus can be used as products.

The results of measurement and observation of the above sections (1)-(3), measured for the LT single crystals containing iron as an additional element, are shown in Table 1 below. Also, the results of measurement and observation of the above section (2) and wafer good product rate, measured for the LT single crystals containing copper, cobalt, nickel, manganese, yttrium or titanium as an additional element, are shown in Table 2 below. Also, the results of measurement of wafer good product rate of the LT single crystal subjected to reduction treatment are shown in Table 3 below.

[Table 1]

| Iron content (wt%) | 0 | 0.001 | 0.002 | 0.005 | 0.01 | 0.02 | 0.10 | 0.50 | 1.00 | 1.20 |
|---|---|---|---|---|---|---|---|---|---|---|
| Curie point of upper portion of crystal (°C) | 602.0 | 602.5 | 602.9 | 603.1 | 603.2 | 603.4 | 608.4 | 625.3 | 647.3 | 654.1 |
| Curie point of lower portion of crystal (°C) | 602.5 | 602.4 | 602.4 | 603.0 | 603.4 | 603.6 | 608.2 | 627.7 | 650.8 | 660.3 |

(continued)

| | | | | | | | | | | |
|---|---|---|---|---|---|---|---|---|---|---|
| Difference in Curie point between upper portion and lower portion (°C) | 0.5 | 0.1 | 0.5 | 0.1 | 0.2 | 0.2 | 0.2 | 2.4 | 3.5 | 6.2 |
| Segregation of iron | None | None | None | None | None | None | None | None | None | Present |
| Crystal defects | None | None | None | None | None | None | None | None | None | Present |
| Good product rate of 350 $\mu$m thick wafers (%) | 95 | 96 | 98 | 100 | 99 | 99 | 98 | 89 | 72 | 68 |
| Good product rate of 200 $\mu$m thick wafers (%) | 79 | 82 | 82 | 99 | 99 | 98 | 97 | 76 | 69 | 60 |
| Good product rate of 150 $\mu$m thick wafers (%) | 58 | 60 | 75 | 94 | 95 | 93 | 91 | 71 | 67 | 55 |

[Table 2]

| Additional element | None | Cu | Co | Ni | Mn | Y | Ti |
|---|---|---|---|---|---|---|---|
| Content (wt%) | 0 | 0.10 | 0.10 | 0.10 | 0.10 | 0.10 | 0.10 |
| Segregation of additional element | None | None | None | None | None | None | None |
| Good product rate of 200 $\mu$m thick wafers (%) | 79 | 97 | 93 | 89 | 91 | 90 | 89 |
| Good product rate of 150 $\mu$m thick wafers (%) | 58 | 91 | 89 | 88 | 87 | 85 | 80 |

[

Table 3]

| Iron content (wt%) | 0 | 0.002 | 0.005 | 0.009 | 0.01 | 0.02 | 0.022 |
|---|---|---|---|---|---|---|---|
| Good product rate of 200 $\mu$m thick wafers (%) | 75 | 80 | 96 | 93 | 95 | 92 | 95 |
| Good product rate of 150 $\mu$m thick wafers (%) | 56 | 73 | 94 | 94 | 94 | 93 | 92 |

The uniformity of composition of the prepared LT single crystals will now be described. The uniformity of composition can be evaluated by the difference between the Curie point of the upper crystal wafer and the Curie point of the lower crystal wafer, which are cut from the LT single crystal.

That is, a smaller difference between the Curie points of the upper portion and lower portion of the single crystal can indicate that the composition is more uniform in the axial direction of the single crystal. Also, when the composition is uniform, neither the segregation of the additional element nor crystal defects occur. Also, the LT single crystal or LN single crystal containing iron shows yellow or orange-colored in the wafer produced from the single crystal. The color of the wafer is uniform throughout the wafer, suggesting that iron is uniformly dispersed in the wafer.

As shown in Table 1, in the LT single crystal containing no additional element, the difference of Curie point between the upper portion and the lower portion of the single crystal was 0.5 °C . That is, because there was little or no difference in Curie point between the upper and lower portions of the single crystal, it can be seen that the composition of the LT single crystal, containing no additional element, was uniform.

Meanwhile, in the LT single crystal containing an iron content of 1.20 wt%, the difference in Curie point between the upper and lower portions of the single crystal was 6.2 °C. This suggests that, in the LT single crystal having an iron content of 1.20 wt%, the composition at the upper and lower portions of the single crystal was not uniform. This is also evident from the segregation or non-segregation of the additional element. If the additional element is not uniformly contained in the crystal, the segregation of the additional element will appear, and crystal defects will tend to occur. In the LT single crystal having an iron content of 1.20 wt%, the segregation of the additional element iron was observed, and crystal defects also occurred.

In the LT single crystals having iron contents of 0.002-1.00 wt%, the difference in Curie point between the upper and lower portions of the crystals was 0.1-3.5 °C. This suggests that the composition of the LT single crystals having iron contents of 0.002-1.00 wt% was uniform.

In addition, in the LT single crystals having iron contents of 0.002-1.00 wt%, the segregation of iron was not observed, and no crystal defects also occurred. Because the single crystals, in which the difference in Curie point between the upper and lower portion thereof is in the above-specified range, have a uniform composition, they are also suitable for the production of piezoelectric substrates for surface acoustic wave filters.

Particularly, the composition of the LT single crystals having iron contents of 0.002-0.1 wt% is more uniform, and thus these single crystals are more preferably used to produce piezoelectric substrates for surface acoustic wave filters.

Also, as can be seen in the results of good product rate at various thicknesses in Table 1 above, in the case of the LT single crystals having iron contents of 0.002-0.1 wt%, the good product rate of the 200 μm thick and 150 μm thick wafers was greatly increased, compared to the case of the LT single crystal containing no additional element.

Also, as can be seen in the results of good product rate in Table 2 above, in the case of the LT single crystals having a copper, cobalt, nickel, manganese, yttrium or titanium content of 0.10 wt%, the good product rate of the 200 μm thick and 150 μm thick wafers was greatly increased, compared to the case of the LT single crystal containing no additional element.

Also, as can be seen in the results of good product rate at various thicknesses of the reduced, iron-containing LT single crystals in Table 3 above, the good product rate was greatly increased even in the single crystals reduced for the inhibition of pyroelectric effects.

The thickness required by prior wafers was 1-0.3 mm, but it was recently reduced to 0.3-0.1 mm according to the requirement for thinning. So, the good product rate above mentioned can be worth practical use.

Also, dicing tests were carried out on the LT single crystal wafer having a thickness of 0.25 mm and a diameter of 4 inches (100 mm) and containing no additional element, the reduced LT single crystal wafer containing no additional element, the LT single crystal wafer containing 0.01 wt% of iron, the reduced LT single crystal wafer containing 0.01 wt% of iron, and the reduced LT single crystal wafer containing 0.005 wt% of iron.

In the dicing test, each of the wafers was cut using a #600 diamond blade having a blade width of 0.2 mmT, at a cutting speed of 10.0 mm/sec, and the number of places where chips larger than 10 μm are formed and observed on the cut plane, was counted. As a result, 11 chipped places were observed in the LT single crystal wafer containing no additional element, and 15 chipped places were observed in the reduced LT single crystal wafers containing no additional element, whereas only one chipped place was observed in the reduced LT single crystal wafer containing 0.005 wt% of iron, and no chipping was observed in the LT single crystal wafer containing 0.01 wt% of iron and in the reduced LT single crystal wafer containing 0.01 wt% of iron.

From these results, it could be seen that, unlike the LT single crystal wafer containing no additional element, the LT single crystal wafers containing 0.005 wt% or 0.01 wt% of iron and the reduced single crystal wafers containing 0.005wt% or 0.01wt% can be diced in a good manner without chipping on the cut plane.

(4) Measurement of deflective strength and elongation modulus

The wafers having the respective thicknesses produced from the LT single crystals containing iron were measured for deflective strength. The measurement of deflective strength was carried out using a three-point bending test by the Shimadzu Autograph machine (A G S -1000B). The test conditions were as follows: a base length of 55 mm, room temperature, an air atmosphere, and a crosshead speed of 0.5 mm/min. Also, the maximum load of the machine was 150 N.

Also, the measurement of elongation modulus was carried out on test samples having a size of 18 mm×10 mm×0.2 mm, cut from the wafers having respective thicknesses, produced from the LT single crystals containing iron. In the same manner as in the measurement of deflective strength, the measurement was carried out using a three-point bending test by the Shimadzu autograph machine (AGS-1000B). The test conditions were as follows: a distance between points of 3.0 mm, room temperature, an air atmosphere, and a crosshead speed of 0.5 mm/min. Herein, the maximum load of the machine was 50 N. The elongation modulus was calculated from bend at break or maximum load in the results of the three-point bending test.

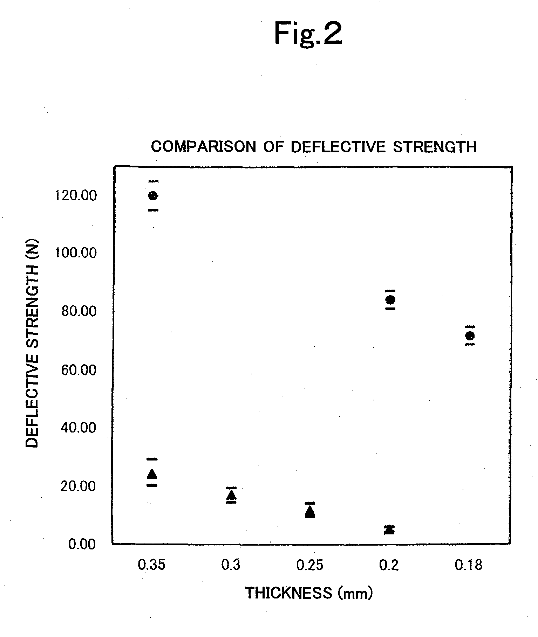

The measurement results are shown in FIG. 2 and Table 4. Table 4 shows the bending strength at break, elongation modulus and elongation modulus ratio of each of the LT single crystal wafers containing iron. In FIG. 2, the x-axis indicates the thickness of the wafer, and the y-axis indicates the deflective strength flexural modulus (N) of the wafers.

In FIG. 2, the symbol ● indicates the results of the LT single crystals having an iron content of 0.02wt%, and the symbol ▲ indicates the results of the LT single crystal containing no additional element.

[Table 4]

|  | Bending strength at break | Young's modulus (N/mm2) | Young's modulus ratio |
|---|---|---|---|
| LT single crystal containing no additional element | 30N | 18006.0 | 1 |
| LT single crystal containing 0.001wt% of iron | 32N | 18001.1 | 1 |
| LT single crystal containing 0.005 wt% of iron | 45N | 17892.3 | 0.99 |
| LT single crystal containing 0.02 wt% of iron | >50N not broken | 17851.6 | 0.91 |

As clearly shown in FIG. 2, the deflective strength of the LT single crystal containing 0.02 wt% of iron has no relationship to the thickness of the wafer, and was greatly increased compared to the LT single crystal containing no additional element. Although not shown in the figure, the deflective strengths of the LT single crystal containing 0.01 wt% of iron and the reduced LT single crystal containing 0.01 wt% of iron were also measured. The deflective strength of the reduced LT single crystal containing 0.01 wt% of iron was not different from the deflective strength of the non-reduced LT single crystal containing 0.01 wt% of iron, and was increased compared to the LT single crystal containing no additional element.

As clearly shown in Table 4, the bending strength of the LT single crystal containing iron was higher than that of the LT single crystal containing no additional element. Particularly, the LT single crystal containing 0.02 wt% of iron did not break up to the maximum load of 50 N. The elongation modulus of the LT single crystals containing 0.005 wt% or 0.02 wt% of iron was lower than that of the LT single crystal containing no additional element.

(5) Observation of cut plane

The LT single crystal wafer containing no additional element and the LT single crystal wafer containing 0.02 wt% of iron were cut with a #600 diamond blade having a blade width of 0.2mmT, at cutting speeds of 5.0 mm/sec and 10.0 mm/sec, and the cut planes were observed with a microscope. The cutting was carried out using a DISCO model DAD-2H/6. The microscopic observation was carried out using KEYENCE model VF-7500.

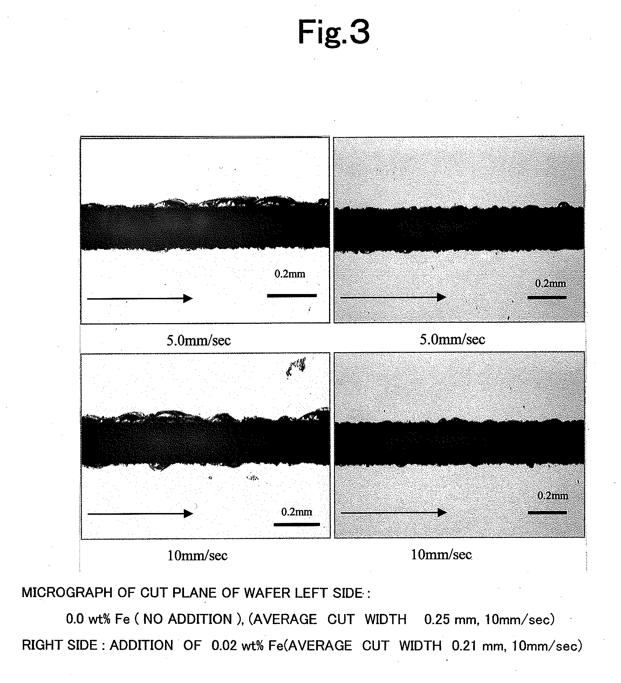

The micrograph of the observed cut plane is shown in FIG. 3. In the figure, the arrow indicates the cutting direction. The left side in FIG. 3 is a photograph of the cut plane of the LT single crystal containing no additional element and the right side is a photograph of the cut plane of the LT single crystal wafer containing 0.02 wt% of iron. Also, in both the left side and the right side in FIG. 3, the upper portion indicates the results at the cutting speed of 5.0 mm/sec, and the lower portion indicates the results at the cutting speed of 10.0 mm/sec. Herein, the cut width observed in the left side in FIG. 3 was 0.25 mm on average, and the cut width observed in the right side in FIG. 3 was 0.21 mm on average.

As shown in FIG. 3, in the LT single crystal wafer containing no additional element, chipping occurred even when it was cut at a cutting speed of 5.0 mm/sec. At a cutting speed of 10.0 mm/sec, large chipping was observed throughout the wafer. On the contrary, in the cut plane of the LT single crystal wafer containing 0.02 wt% of iron, little or no chipping was observed at any of the cutting speeds.

With respect to the cut width, when the blade width was 0.2 mm, the cut plane of the LT single crystal wafer containing no additional element showed a cut width of 0.26 mm on average, and the cut plane of the LT single crystal wafer containing 0.02 wt% of iron showed a cut width of 0.21 mm on average. It was confirmed that the LT single crystal wafer containing 0.02 wt% of iron shows good processability in a cutting process, and can be cut with precision.

Although not shown in the figure, the cut plane of the reduced LT single crystal water containing 0.01 wt% of iron was observed. In the reduced LT single crystal wafer containing 0.01 wt% of iron, little or no chipping was observed, as in the reduced LT single crystal wafer containing 0.02 wt% of iron. As a result, it was confirmed that the reduced LT single crystal wafer containing 0.01 wt% of iron shows good processability in a cutting process, and can be cut with precision.

(6) Thermal impact test

100 sheets of 0.2 mm thick wafers, stored at room temperature (20 °C) and containing iron, was placed on a hot plate heated to 200 °C. After the wafers had been placed on the hot plate for about 5 minutes, they were taken off of the hot plate and rapidly cooled to room temperature. After a series of processes, the number of broken wafers was counted, and the breakage ratio was calculated. When the wafers were placed on the hot plate, they were heated at a rate of about 90°C/min.

$$\text{Breakage ratio (\%)} = \text{number of broken wafers/100 wafers} \times 100$$

As a result, the breakage ratio of the LT single crystal wafers containing no additional element was 17%, whereas the breakage ratio of the LT single crystals containing 0.001 wt% of iron was 10%, the breakage ratio of the LT single crystal wafers containing 0.002 wt% of iron was 4%, the breakage ratio of the LT single crystal wafers containing 0.005 wt% of iron was 2%, and the breakage ratios of the LT single crystal wafers containing 0.01 wt% of iron and the LT single crystal wafers containing 0.1 wt% of iron were 0%.

As described above, the thermal shock characteristics of the LT single crystal wafers containing 0.002-0.1 wt% of iron as an additional element were greatly improved.

Also, the thermal shock test was performed on the reduced wafers. This was carried out using a modification of the above-described method.

100 sheets of each of the 0.25 mm thick LT single crystal wafers, stored at room temperature (20°C) and containing no additional element, the reduced LT single crystal wafers containing no additional element, the LT single crystal wafer containing 0.01 wt% of iron, the reduced LT single crystal wafers containing 0.01 wt% of iron, and the reduced LT single wafers containing 0.005 wt% of iron, were placed on a hot plate heated to 300 °C. Immediately after each of the wafers was placed on the hot plate, it was taken off of the hot plate and rapidly cooled to room temperature. After a series of processes, the number of broken wafers was counted, and the breakage ratio was calculated as described above.

As a result, the breakage ratio of the LT single crystal wafers containing no additional element was 24%, and the breakage ratio of the reduced LT single crystal wafers containing no additional element was 17%. In contrast, the breakage ratios of the LT single crystal wafers containing 0.01 wt% of iron, the reduced LT single crystal wafers containing 0.01 wt% of iron, and the reduced LT single crystal wafers containing 0.005 wt% of iron were all 0%.

As described above, the thermal shock characteristics of the reduced LT single crystal wafers containing 0.01 wt% or 0.005 wt% of iron as an additional element did not change, even when they were subjected to reduction treatment, and the breakage ratio thereof was low.

(7) Test of effect of inhibiting pyroelectric effects

The volume resistivities and surface potentials of the reduced LT single crystal wafer containing no additional element and the reduced LT single crystal wafer containing iron were measured.

The volume resistivities and surface potentials of the 0.25 mm thick LT single wafer containing no additional element, the reduced LT single crystal wafer containing no additional element, the LT single crystal containing 0.01 wt% of iron, the reduced LT single crystal wafer containing 0.01 wt% of iron, and the reduced LT single crystal wafer containing 0.005 wt% of iron were measured.

The volume resistivity was measured using model DSM-8103 (manufactured by TOA DKK). Also, the surface potential was measured by placing each wafer on a plate maintained at 85°C and measuring the change in the surface potential from room temperature (20°C) to 85°C, and the peak was expressed as the surface potential value.

Volume resistivity, surface potential and wafer color are shown in Table 5 below.

[Table 5]

|  | LT single crystal wafer containing additional element | reduced LT single crystal wafer containing no additional element | LT single crystal wafer containing 0.01 wt% of iron | reduced LT single crystal wafer containing 0.005 wt% of iron | reduced LT single crystal wafer containing 0.01 wt% of iron |
|---|---|---|---|---|---|
| Color | White | Gray | Yellow | Dark yellow | Dark yellow |
| Volume resistivity ($\Omega \cdot$cm) | E+14~15 | 2.13E+ 11 | 4.50E+13 | 7.60E+10 | 8.2E+10 |

(continued)

|  | LT single crystal wafer containing additional element | reduced LT single crystal wafer containing no additional element | LT single crystal wafer containing 0.01 wt% of iron | reduced LT single crystal wafer containing 0.005 wt% of iron | reduced LT single crystal wafer containing 0.01 wt% of iron |
|---|---|---|---|---|---|
| Surface potential (kv) | -4.5 | -0.25 | -3.5 | -0.10 | -0.10 |

As shown in Table 5 above, the LT single crystal wafer containing 0.01 wt% of iron as an additional element had low volume resistivity and low surface potential compared to those of the LT single crystal wafer containing no additional element.

Also, the reduced LT single crystal wafers containing 0.005 wt% or 0.01 wt% of iron had low volume resistivity and low surface potential compared to those of the reduced LT single crystal wafer containing no additional element. Thus, it was observed that the reduced LT single crystal wafers containing 0.005 wt% or 0.01 wt% of iron had the effect of inhibiting pyroelectric effects due to reduction treatment.

In addition, the 0.25 mm thick wafer of the reduced LT single crystal wafer containing 0.01 wt% of iron and the reduced LT single crystal wafer of the thick wafer containing no additional element were measured for the changes in volume resistivity and surface potential before and after thermal treatment. In the thermal treatment, each of the wafers was maintained on a hot plate at 300 °C for 1 hour, and was then cooled to room temperature, and the volume resistivity and surface potential thereof were measured.

The volume resistivity was measured with the above-described model DSM-8103 (manufactured by TOA DKK). Also, the surface potential was measured with a surface potential meter. The surface potential of each wafer, before thermal treatment and after thermal treatment cooled to room temperature, was measured by placing each wafer on the plate maintained at 85 °C and measuring the change in surface potential from 20°C to 85 °C, and the peak was expressed as the surface potential value.

The reduced LT single crystal wafer containing no additional element was measured at n=1, and the reduced LT single crystal wafers containing 0.01 wt% of iron were measured at n=3.

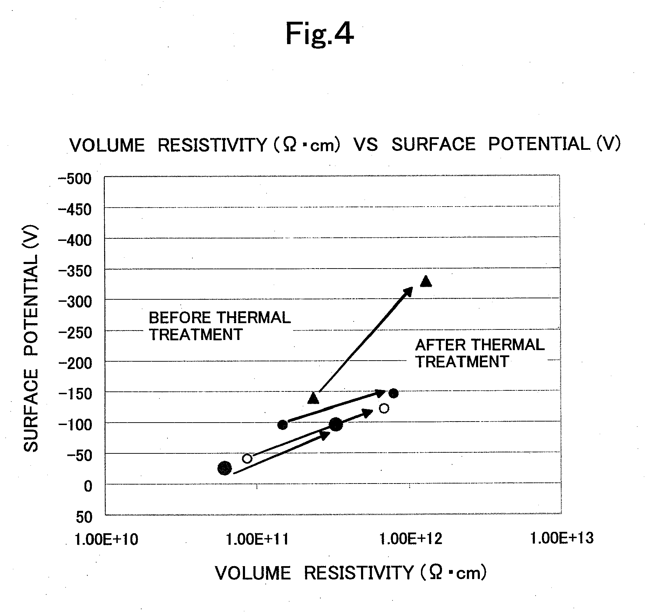

The measurement results are shown in Table 6 and FIG. 4.

[Table 6]

|  | Before thermal treatment | | After thermal treatment | |
|---|---|---|---|---|
|  | Volume resistivity ($\Omega \cdot$cm) | Surface potential (kv) | Volume resistivity ($\Omega \cdot$cm) | Surface potential (kv) |
| reduced LT single crystal wafer containing no additional element | 2.34E+11 | -140 | 1.30E+12 | -330 |
| reduced LT single crystal wafer 1 containing 0.01 wt% of iron | 1.50E+11 | -95 | 7.98E+ 11 | -145 |
| reduced LT single crystal wafer 2 containing 0.01 wt% of iron | 8.78E+ 10 | -40 | 6.98E+ 11 | -120 |
| reduced LT single crystal wafer 3 containing 0.01 wt% of iron | 6.21E+ 10 | -25 | 3.32E+ 11 | -95 |

In FIG. 4, the symbol ▲ indicates the measurement results for the reduced LT single crystal wafer containing no additional element, and three kinds of circle symbols indicate measurement results for the reduced LT single crystal wafers containing 0.01 wt% of ron, respectively. In the figure, the circle symbol of the arrow indicates values before thermal treatment, and the arrow symbol of the arrow indicates values after thermal treatment.

As shown in Table 6 and FIG. 4, the reduced LT single crystal wafers containing 0.01 wt% of iron had low volume resistivity and low surface potential as in the reduced LT single crystal wafer containing no additional element.

In the comparison of the surface potentials after thermal treatment, it was seen that the reduced LT single crystal wafer containing 0.01 wt% of iron had low surface potential and showed little variation in the surface potential after thermal treatment, compared to the reduced LT single crystal wafer containing no additional element.

In the comparison of the volume resistivities after thermal treatment, it was seen that the reduced LT single crystal wafer containing 0.01 wt% of iron had low volume resistivity, and that compared to the reduced LT single crystal wafer containing no additional element, the volume resistivity after thermal treatment was difficult to increase, that is, the conductivity of the wafer was maintained, suggesting that the wafer had a high antistatic effect.

The increase in volume resistivity is thought to occur due to oxidation. The reduced LT single crystal wafer containing 0.01 wt% of iron, for this reason, was difficult to oxidize again, even when it was exposed to a high temperature of 300 °C.

This indicates that the use of the LT single crystal wafer in surface acoustic wave filters will provide a great effect.

Processes of producing surface acoustic wave filters include several processes causing changes in the temperature of piezoelectric substrates, for example, the formation of an electrode thin film on the surface of the piezoelectric substrate, and pre-baking or post-baking in photolithography. However, the LT single crystal or the LN single crystal, which are materials for the filters, are characterized in that they have high pyroelectric coefficients and high resistance. For this reason, surface charges are generated due to slight changes in temperature. Also, the electric charges, once generated, are accumulated, and the charged state persists as long as external charge removal treatment is not carried out.

For this reason, when the LT single crystal or the LN single crystal is used as a piezoelectric substrate in a process of producing a surface acoustic wave filter, the generation of static electricity in the piezoelectric substrate due to the change in temperature is problematic. When the piezoelectric substrate is electrically charged, the discharge of static electricity in the piezoelectric substrate occurs, thus causing crack or breakage. Also, the electrode formed on the surface of the piezoelectric substrate can be short-circuited due to static electricity. Moreover, fine metal powder, waste, dust and the like, which are generated in the production process, can gravitate to the piezoelectric substrate surface due to static electricity, the electrode can be short-circuited due to these particles, and the electrode can be opened, such that it can be broken.

Recently, it has been necessary to carry out the process of producing surface acoustic wave filters at high temperature.

As described above, the volume resistivity of the reduced LT single crystal wafer containing 0.01 wt% of iron is difficult to increase even after thermal treatment at 300 °C, unlike the reduced LT single crystal wafer containing no additional element, that is, the conductivity thereof is maintained, leading to a high antistatic effect. Thus, it is thought that the use of the reduced LT single crystal wafer containing 0.01 wt% of iron in surface acoustic wave filters will provide a great effect.

While the invention has been shown and described with respect to the preferred embodiments, it will be understood by those skilled in the art that various changes and modifications may be made without departing from the spirit and scope of the invention as defined in the following claims.

**Claims**

1. A lithium tantalate single crystal or a lithium niobate single crystal, which contains at least one additional element selected from the group consisting of iron, copper, manganese, molybdenum, cobalt, nickel, zinc, carbon, magnesium, titanium, tungsten, indium, tin, rhenium, scandium, rhodium, ruthenium, palladium, silver, platinum, gold, yttrium, neodymium, iridium, germanium, barium, cesium, strontium, gallium, cerium and other transition elements at a ratio of from 0.002wt% or more to 0.1 wt% or less, and has excellent stress shock characteristics and thermal shock characteristics.

2. The lithium tantalate single crystal or lithium niobate single crystal of Claim 1, wherein the additional element is contained at a ratio of from 0.002wt% or more to less than 0.01 wt%.

3. The lithium tantalate single crystal or lithium niobate single crystal of Claim 1 or 2, wherein the additional element is iron, and the single crystal shows yellow or orange-colored in a wafer produced therefrom.

4. The lithium tantalate single crystal or lithium niobate single crystal of any one of Claims 1 to 3, which is subjected to reduction treatment.

5. The lithium tantalate single crystal or lithium niobate single crystal of Claim 4, wherein the additional element is iron, and the reduced single crystal shows dark yellow or dark orange in a wafer produced therefrom.

6. A method for producing a reduced lithium tantalate single crystal or lithium niobate single crystal, comprising the steps of:

preparing a lithium tantalate single crystal or a lithium niobate single crystal, which contains at least one additional element selected from the group consisting of iron, copper, manganese, molybdenum, cobalt, nickel, zinc, carbon, magnesium, titanium, tungsten, indium, tin, rhenium, scandium, rhodium, ruthenium, palladium, silver, platinum, gold, yttrium, neodymium, iridium, germanium, barium, cesium, strontium, gallium, cerium and other transition elements at a ratio of from 0.002wt% or more to 0.1 wt% or less and has excellent stress shock characteristics and thermal shock characteristics; and
reducing the prepared single crystal.

7. A surface acoustic wave filter comprising a piezoelectric substrate produced from a lithium tantalate single crystal or a lithium niobate single crystal, which contains at least one additional element selected from the group consisting of iron, copper, manganese, molybdenum, cobalt, nickel, zinc, carbon, magnesium, titanium, tungsten, indium, tin, rhenium, scandium, rhodium, ruthenium, palladium, silver, platinum, gold, yttrium, neodymium, iridium, germanium, barium, cesium, strontium, gallium, cerium and other transition elements at a ratio of from 0.002wt% or more to 0.1 wt% or less, and has excellent stress shock characteristics and thermal shock characteristics.

8. The surface acoustic wave filter of Claim 7, wherein the additional element is contained at a ratio of from 0.002wt% or more to less than 0.01 wt % .

9. The surface acoustic wave filter of Claim 7 or 8, wherein the additional element is iron, and the piezoelectric substrate shows yellow or orange-colored.

10. The surface acoustic wave filter of Claim 7 or 8, wherein the lithium tantalate single crystal or the lithium niobate single crystal was subjected to reduction treatment.

11. The surface acoustic wave filter of Claim 7, wherein the additional element is iron, and the piezoelectric substrate shows dark yellow or dark orange.

12. A method for producing a surface acoustic wave filter, comprising the steps of:

preparing a piezoelectric substrate produced from a lithium tantalate single crystal or a lithium niobate single crystal, which contains at least one additional element selected from the group consisting of iron, copper, manganese, molybdenum, cobalt, nickel, zinc, carbon, magnesium, titanium, tungsten, indium, tin, rhenium, scandium, rhodium, ruthenium, palladium, silver, platinum, gold, yttrium, neodymium, iridium, germanium, barium, cesium, strontium, gallium, cerium and other transition elements at a ratio of from 0.002wt% or more to 0.1 wt% or less, and has excellent stress shock characteristics and thermal shock characteristics;
forming an electrode thin film on the surface of the piezoelectric substrate; and
patterning the electrode thin film by photolithography to form an electrode having a given shape.

13. The method of Claim 12, wherein the additional element is contained at a ratio of from 0.002wt% or more to less than 0.01 wt%.

14. The method of Claim 12 or 13, wherein the step of preparing the piezoelectric substrate comprises a step of subjecting the piezoelectric substrate to reduction treatment.

Fig.1

# Fig.2

COMPARISON OF DEFLECTIVE STRENGTH

# Fig.3

MICROGRAPH OF CUT PLANE OF WAFER LEFT SIDE :

    0.0 wt% Fe ( NO ADDITION ), (AVERAGE CUT WIDTH 0.25 mm, 10mm/sec)

RIGHT SIDE : ADDITION OF 0.02 wt% Fe(AVERAGE CUT WIDTH 0.21 mm, 10mm/sec)

# Fig.4

VOLUME RESISTIVITY (Ω·cm) VS SURFACE POTENTIAL (V)

## INTERNATIONAL SEARCH REPORT

| International application No. |
|---|
| PCT/JP2006/314929 |

| A. CLASSIFICATION OF SUBJECT MATTER |
|---|
| *C30B29/30*(2006.01)i, *H01L41/09*(2006.01)i, *H01L41/18*(2006.01)i, *H01L41/22*(2006.01)i, *H03H9/25*(2006.01)i |

According to International Patent Classification (IPC) or to both national classification and IPC

| B. FIELDS SEARCHED |
|---|
| Minimum documentation searched (classification system followed by classification symbols)<br>C30B29/30, H01L41/09, H01L41/18, H01L41/22, H03H9/25 |

Documentation searched other than minimum documentation to the extent that such documents are included in the fields searched

| Jitsuyo Shinan Koho | 1922-1996 | Jitsuyo Shinan Toroku Koho | 1996-2006 |
|---|---|---|---|
| Kokai Jitsuyo Shinan Koho | 1971-2006 | Toroku Jitsuyo Shinan Koho | 1994-2006 |

Electronic data base consulted during the international search (name of data base and, where practicable, search terms used)
WPI

### C. DOCUMENTS CONSIDERED TO BE RELEVANT

| Category* | Citation of document, with indication, where appropriate, of the relevant passages | Relevant to claim No. |
|---|---|---|
| X<br>Y | JP 10-45497 A (Director General of National Institute for Research in Inorganic Materials of Science and Technology Agency), 17 February, 1998 (17.02.98), Claims 1 to 3; Par. No. [0023] & US 5904912 A | 1-6<br>7-14 |
| X<br>Y | JP 2004-254114 A (YAMAJU CERAMICS CO., LTD.), 09 September, 2004 (09.09.04), Claims 1 to 6 (Family: none) | 1,3<br>7-14 |
| X | JP 11-35393 A (Hitachi Metals, Ltd.), 09 February, 1999 (09.02.99), Claims 1 to 3; Par. No. [0018]; table 1 (Family: none) | 1-3 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 20 September, 2006 (20.09.06) | 03 October, 2006 (03.10.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

International application No.

PCT/JP2006/314929

C (Continuation).　DOCUMENTS CONSIDERED TO BE RELEVANT

| Category* | Citation of document, with indication, where appropriate, of the relevant passages | Relevant to claim No. |
|---|---|---|
| X | JP 11-191239 A　(Kyocera Corp.),<br>13 July, 1999 (13.07.99),<br>Claims 1 to 4; Par. Nos. [0015], [0016],<br>[0036] to [0064]<br>(Family: none) | 1-3 |
| X | JP 11-30945 A　(Kyocera Corp.),<br>02 February, 1999 (02.02.99),<br>Claims 1, 2; Par. Nos. [0009] to [0011]<br>(Family: none) | 1,3 |
| A | JP 2004-300015 A　(Pioneer Electronic Corp.),<br>28 October, 2004 (28.10.04),<br>& US 2004/0234867 A1 | 1-14 |
| A | JP 6-340497 A　(Toshiba Corp.),<br>13 December, 1994 (13.12.94),<br>(Family: none) | 1-14 |
| P,X<br>P,A | WO 2005/103343 A1　(Yamaju Ceramics Co., Ltd.),<br>03 November, 2005 (03.11.05),<br>Claims 1 to 6; page 9, line 21 to page 10,<br>line 9<br>& JP 2005-314137 A　　& US 2005/0284359 A1 | 1-6<br>7-14 |

Form PCT/ISA/210 (continuation of second sheet) (April 2005)